(19) Europäisches Patentamt
European Patent Office
Office européen des brevets

(11) EP 4 317 237 B1

(12) **EUROPEAN PATENT SPECIFICATION**

(45) Date of publication and mention of the grant of the patent:
**11.03.2026 Bulletin 2026/11**

(21) Application number: **22780597.5**

(22) Date of filing: **25.03.2022**

(51) International Patent Classification (IPC):
***C08G 59/20*** *(2006.01)* ***C08G 59/40*** *(2006.01)*
***C08L 63/00*** *(2006.01)* ***C08K 3/013*** *(2018.01)*

(52) Cooperative Patent Classification (CPC):
(C-Sets available)
**H10W 42/121; C08G 59/3218; C08G 59/621; C08K 3/36; C08L 63/00; H10W 74/473** (Cont.)

(86) International application number:
**PCT/JP2022/014525**

(87) International publication number:
**WO 2022/210384 (06.10.2022 Gazette 2022/40)**

(54) **RESIN COMPOSITION FOR ENCAPSULATING AND ELECTRONIC DEVICE USING SAME**

HARZZUSAMMENSETZUNG ZUR VERKAPSELUNG UND ELEKTRONISCHE VORRICHTUNG DAMIT

COMPOSITION DE RÉSINE POUR ENCAPSULATION ET DISPOSITIF ÉLECTRONIQUE UTILISANT CELLE-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.03.2021 JP 2021060421**

(43) Date of publication of application:
**07.02.2024 Bulletin 2024/06**

(73) Proprietor: **Sumitomo Bakelite Co.Ltd.**
**Shinagawa-ku**
**Tokyo 140-0002 (JP)**

(72) Inventor: **TAKAHASHI, Yui**
**Tokyo 140-0002 (JP)**

(74) Representative: **Müller-Boré & Partner Patentanwälte PartG mbB**
**Friedenheimer Brücke 21**
**80639 München (DE)**

(56) References cited:
**WO-A1-2007/007827**
**WO-A1-2020/090491**
**CN-A- 109 111 688**
**JP-A- 2006 206 827**
**JP-A- 2011 026 419**
**JP-A- 2012 241 151**
**JP-A- 2012 241 151**
**JP-A- 2014 005 383**
**JP-A- 2014 179 388**
**JP-A- 2016 141 757**
**JP-A- 2017 157 618**
**JP-A- S61 283 615**
**KR-A- 20130 074 664**
**US-A1- 2007 207 322**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08L 63/00, C08K 3/36**

## Description

### TECHNICAL FIELD

The present invention relates to a resin composition for encapsulating and an electronic device using the same. More specifically, the present invention relates to a resin composition for encapsulating an electronic component such as a semiconductor, and a device including the electronic component encapsulated with such a resin composition.

### BACKGROUND ART

In recent years, from the viewpoint of effective use of electric energy, silicon carbide (SiC) or gallium nitride (GaN) power semiconductor devices equipped with elements using SiC or GaN have attracted attention (for example, see Patent Document 1).

As compared with elements using Si in the related art, since such elements cannot only have significantly reduced power loss, but can also operate at higher voltages, larger currents, or at higher temperatures above 200°C, it is expected to develop into applications which are difficult to apply to Si power semiconductor devices in the related art.

In this way, in the elements which can operate under harsh conditions, such as the elements (semiconductor element) using SiC or GaN, a semiconductor encapsulating material provided in the semiconductor device to protect these elements is also required to have higher heat resistance than before.

Here, in the Si power semiconductor devices in the related art, as the semiconductor encapsulating material, from the viewpoint of adhesiveness, electrical stability, and the like, an encapsulating material containing a cured product of an epoxy-based resin composition as a main material has been used.

For example, Patent Document 2 describes an epoxy resin composition comprising (A) a mixture of a naphthalene type epoxy resin and an anthracene type epoxy resin, (B) a curing agent in the form of a naphthalene type phenolic resin, and (C) an inorganic filler, which is best suited for semiconductor encapsulation.

Furthermore, Patent Document 3 describes a resin composition for sealing an electronic part that has high moldability, high adhesiveness, and high long-term thermal resistance, and to provide an electronic part device using the resin composition.

A glass transition temperature (Tg) is generally used as an index representing heat resistance of the cured product of such a resin composition. This is because the resin composition (cured product) for encapsulating is rubber-like in a temperature range of Tg or higher, which reduces its strength and adhesive strength. Therefore, as a method for increasing Tg, a technique such as increasing a crosslinking density by reducing an epoxy group equivalent of the epoxy resin contained in the resin composition or a hydroxyl group equivalent of a curing agent (phenolic resin curing agent), and making a structure connecting functional groups (epoxy group and hydroxyl group) rigid has been considered.

On the other hand, in a case where the present inventors studied on a resin composition using such a high Tg epoxy resin as described above, it is clear that there is room for improvement in results of High Accelerated Stress Test (HAST).

Therefore, in order to improve the heat resistance of the resin composition, an achievement of a designed resin composition that a resin skeleton formed by the epoxy resin and the curing agent and the density of functional groups are designed under the optimum conditions to have a high Tg, as well as excellent adhesiveness and high-temperature reliability, is desired.

### RELATED DOCUMENT

### PATENT DOCUMENT

[Patent Document 1] Japanese Unexamined Patent Publication No. 2005-167035
[Patent Document 2] US 2007/207322 A1
[Patent Document 3] JP 2012 241151 A

### SUMMARY OF THE INVENTION

### TECHNICAL PROBLEM

In view of such a background, the present invention provides a resin composition capable of forming a semiconductor encapsulating material having a high glass transition temperature and excellent adhesiveness and

high-temperature reliability. The present invention also provides an electronic device obtained by encapsulating an electronic component with such a resin composition.

## SOLUTION TO PROBLEM

As a result of studies, the present inventors have completed the invention provided below and achieved the above-described objects.

The present invention and the preferred embodiments are defined in the appended set of claims.

## ADVANTAGEOUS EFFECTS OF INVENTION

According to the present invention, there are provided a resin composition for encapsulating and an electronic device, which have high Tg and are excellent in balance between adhesiveness and high-temperature reliability.

## DESCRIPTION OF EMBODIMENTS

Hereinafter, embodiments of the present invention will be described in detail based on embodiment.

### <Resin composition>

First, the resin composition according to the present embodiment will be described.

The resin composition according to the present embodiment contains an epoxy resin, a curing agent, and an inorganic filler, in which the epoxy resin includes an epoxy resin having 2 or more and 6 or less epoxy groups in a molecule, the curing agent includes a compound having 2 or more active hydrogens in a molecule, and a lower limit value of an equivalent ratio which is a ratio of an epoxy equivalent of the epoxy resin to an active hydrogen equivalent of the curing agent is 1.45 or more, preferably 1.5 or more, and more preferably 1.6 or more. In addition, an upper limit value of the above-described equivalent ratio is 2.0 or less, preferably 1.85, and more preferably 1.75.

By setting the amount of epoxy groups in the above-described epoxy resin within the above-described range, a crosslinking density between the epoxy resin and the curing agent is improved, which is preferable. This has an effect of inhibiting movement and reaction of free ions contained in the resin composition, and preventing deterioration of the resin.

In addition, by setting the amount of epoxy groups in the above-described epoxy resin within the above-described range, it is possible to reduce a residual amount of unreacted curing agent and reduce influence of polarization of the unreacted curing agent.

In addition, by setting the amount of active hydrogens in the above-described curing agent within the above-described range, the crosslinking density between the epoxy resin and the curing agent is improved, which is preferable. This has the effect of inhibiting movement and reaction of free ions contained in the resin composition, and preventing deterioration of the resin.

Furthermore, by setting the above-described equivalent ratio to the above-described lower limit value or more, it is possible to reduce the residual amount of unreacted curing agent and reduce the influence of polarization of the unreacted curing agent, and the crosslinking density between the epoxy resin and the curing agent is improved, which is suitable. This has the effect of inhibiting movement and reaction of free ions contained in the resin composition, preventing deterioration of the resin, and improving high-temperature reliability of the resin composition. In addition, by setting the above-described equivalent ratio to the above-described upper limit value or less, fluidity of the resin composition can be more suitable, and for example, in a case where the resin composition according to the present embodiment is used for encapsulating an electronic component, adhesiveness between the resin composition and a lead frame or a substrate can be improved.

The above-described epoxy equivalent of the epoxy resin can be measured according to JIS K 7236, and is a mass of a resin including one equivalent of epoxy group. In addition, in the present embodiment, in a case where a plurality of types of epoxy resins are mixed and used, the epoxy equivalent is the number of equivalents after mixing the plurality of types of epoxy resins.

The above-described active hydrogen equivalent is the number of functional groups having an active hydrogen reactive with the epoxy group (hereinafter, also referred to as an active hydrogen group; including a functional group having a latent active hydrogen, which generates an active hydrogen by hydrolysis or the like, and a functional group which exhibits an equivalent curing action).

Specific examples of the active hydrogen group include an acid anhydride group, a carboxyl group, an amino group, and a phenolic hydroxyl group. Regarding the active hydrogen group, the carboxyl group (-COOH) and the phenolic hydroxyl group (-OH) are calculated as 1 mol, and the amino group ($-NH_2$) is calculated as 2 mol. In addition, in a case where the active hydrogen group is not clear, the active hydrogen equivalent can be determined by measurement. For

example, by reacting a monoepoxy resin with a known epoxy equivalent, such as phenyl glycidyl ether, with a curing agent with an unknown active hydrogen equivalent and measuring the amount of the monoepoxy resin consumed, the active hydrogen equivalent of the curing agent used can be obtained.

In the present embodiment, in a case where a plurality of types of curing agents are mixed and used, the active hydrogen equivalent is the number of equivalents after mixing the plurality of types of curing agents.

Hereinafter, each component contained in the resin composition will be described.

(Epoxy resin)

In the present embodiment, the epoxy resin includes a monomer represented by General Formula (1).

[Chem. 1]

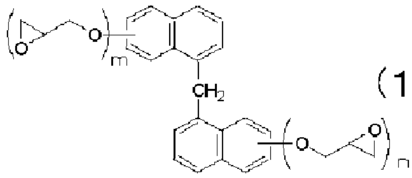

(1)

In General Formula (1), m and n represent the number of epoxy groups in a naphthalene ring, and each independently represent an integer of 1 to 3.

As the monomer of General Formula (1), it is preferable to use any one or more of the followings.

[Chem. 2]

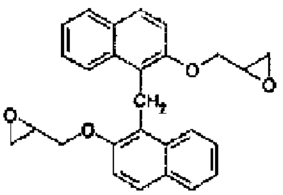

(1-1)

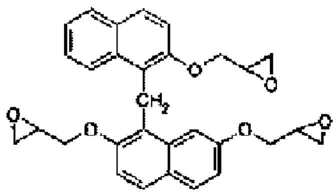

(1-2)

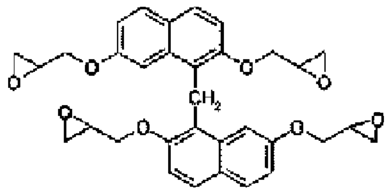

(1-3)

In addition to the epoxy resin represented by General Formula (1) described above, examples of the epoxy resin which can be used in the present embodiment include known epoxy resins which are generally used in an epoxy resin composition for encapsulating. Examples of the known epoxy resins include resins obtained by epoxidizing a novolac resin which is obtained by condensation or co-condensation of phenols such as phenol, cresol, xylenol, resorcinol, catechol, bisphenol A, and bisphenol F and/or naphthols such as α-naphthol, β-naphthol, and dihydroxynaphthalene with a compound having an aldehyde group, such as formaldehyde, benzaldehyde, and salicylaldehyde, in the presence of an acid catalyst, the resins including phenol novolac-type epoxy resins and o-cresol novolac-type epoxy resins; diglycidyl ethers such as bisphenol A, bisphenol F, bisphenol S, and bisphenol A/D; biphenyl-type epoxy resins which are diglycidyl ethers of alkyl-substituted or unsubstituted biphenols; epoxidized products of aralkyl-type resins, such as a phenol aralkyl-type resin synthesized from phenols and dimethoxyparaxylene or bis(methoxymethyl)biphenyl, a biphenylene skeleton phenol aralkyl-type resin, and a naphthol aralkyl-type resin; stilbene-type epoxy resins; hydroquinone-type epoxy resins;

glycidyl ester-type epoxy resins obtained by reaction of polybasic acid such as phthalic acid and dimer acid with epichlorohydrin; glycidyl amine-type epoxy resins obtained by reaction of polyamine such as diaminodiphenylmethane and isocyanuric acid with epichlorohydrin; dicyclopentadiene-type epoxy resins which are epoxidized products of a co-condensation resin of dicyclopentadiene and phenols; triphenolmethane-type epoxy resins; trimethylolpropane-type epoxy resins; terpene-modified epoxy resins; linear aliphatic epoxy resins obtained by oxidizing an olefin bond with peracid such as peracetic acid; alicyclic epoxy resins; and epoxy resins obtained by modifying these epoxy resins with silicone, acrylonitrile, butadiene, isoprene rubber, polyamide resin, and the like.

In addition, in one embodiment of the present invention, the epoxy resin including the monomer represented by General Formula (1) described above may be used alone, the above-described known epoxy resin other than the monomer represented by General Formula (1) described above may be used alone, or one or two or more epoxy resins selected from the above-described known epoxy resins and the epoxy resin including the monomer represented by General Formula (1) described above may be mixed and used. Among these, it is more preferable that the above-described epoxy resin is a mixture of the epoxy resin including the monomer represented by General Formula (1) described above and one or two or more epoxy resins different from the monomer.

In the present embodiment, from the viewpoint of achieving excellent fluidity during molding and improving fillability and adhesiveness, a content of all epoxy resins in the resin composition for encapsulating is preferably 5% by mass or more, more preferably 6% by mass or more, and still more preferably 7% by mass or more with respect to the entire resin composition for encapsulating.

In addition, from the viewpoint of improving high-temperature reliability and reflow resistance of a semiconductor device obtained by using the resin composition for encapsulating, the content of all epoxy resins in the resin composition for encapsulating is preferably 15% by mass or less, more preferably 14% by mass or less, and still more preferably 13% by mass or less with respect to the entire resin composition for encapsulating.

In the present embodiment, from the viewpoint of high-temperature reliability, it is preferable that the resin composition contains as few Na ions and Cl ions as ionic impurities, and S ions.

In the present embodiment, from the viewpoint of achieving excellent fluidity during molding and improving fillability and adhesiveness, the epoxy equivalent of all epoxy resins in the resin composition for encapsulating is preferably 100 g/eq or more, more preferably 120 g/eq or more, and still more preferably 150 g/eq or more.

In addition, from the viewpoint of improving high-temperature reliability and reflow resistance of the semiconductor device obtained by using the resin composition for encapsulating, the epoxy equivalent of all epoxy resins in the resin composition for encapsulating is preferably 500 g/eq or less, more preferably 480 g/eq or less, and still more preferably 450 g/eq or less.

(Curing agent)

Examples of the curing agent which can be used in the present embodiment include known curing agents which are generally used in the epoxy resin composition for encapsulating. Specific examples of the known curing agents include phenol-based curing agents and amine-based curing agents (curing agents having an amino group).

Examples of the phenol-based curing agent include novolac-type phenol resins obtained by condensation or co-condensation of phenols such as phenol, cresol, resorcinol, catechol, bisphenol A, bisphenol F, and phenylphenol, aminophenol and/or naphthols such as $\alpha$-naphthol, $\beta$-naphthol, and dihydroxynaphthalene with a compound having an aldehyde group, such as formaldehyde, benzaldehyde, and salicylaldehyde, in the presence of an acid catalyst; polyfunctional phenol resins such as a triphenylmethane-type phenol resin and a biphenylene skeleton-containing polyfunctional phenol resin; phenol aralkyl-type phenol resins such as a biphenylene skeleton-containing polyfunctional phenol resin synthesized from phenols and/or naphthols and dimethoxyparaxylene or bis(methoxymethyl)biphenyl; dicyclopentadiene-type phenol resins; and terpene-modified phenol resins.

Examples of the amine-based curing agent include linear aliphatic diamines having 2 to 20 carbon atoms, such as ethylenediamine, trimethylenediamine, tetramethylenediamine, and hexamethylenediamine, m-phenylene diamine, p-phenylene diamine, p-xylene diamine, 4,4'-diaminodiphenylmethane, 4,4'-diaminodiphenylpropane, 4,4'-diaminodiphenyl ether, 4,4'-diaminodiphenyl sulfone, 4,4'-diaminodicyclohexane, bis(4-aminophenyl)phenylmethane, 1,5-diaminonaphthalene, m-xylene diamine, p-xylene diamine, 1,1-bis(4-aminophenyl)cyclohexane, and dicyanodiamide.

Examples of other curing agents include polyoxystyrenes such as polyparaoxystyrene; acid anhydrides including alicyclic acid anhydrides such as hexahydrophthalic anhydride (HHPA) and methyltetrahydrophthalic anhydride (MTHPA) and aromatic acid anhydrides such as trimellitic anhydride (TMA), pyromellitic anhydride (PMDA), and benzophenonetetracarboxylic acid (BTDA); polymercaptan compounds such as polysulfide, thioester, and thioether; isocyanate compounds such as isocyanate prepolymer and blocked isocyanate; and organic acids such as carboxylic acid-containing polyester resin.

Among these, as the curing agent used in the resin composition for encapsulating semiconductor, from the viewpoint of adhesiveness and high-temperature reliability, it is preferable to include one or two kinds of a polyfunctional

phenol resin and a phenol aralkyl-type phenol resin, and it is more preferable to include a triphenylmethane-type phenol resin or a biphenylene skeleton-containing polyfunctional phenol resin.

These may be used alone, or in combination of two or more thereof.

In the present embodiment, from the viewpoint of achieving excellent fluidity during molding and improving fillability and adhesiveness, a content of the curing agent in the resin composition for encapsulating is preferably 1% by mass or more, more preferably 2% by mass or more, and still more preferably 3% by mass or more with respect to the entire resin composition for encapsulating.

In addition, from the viewpoint of improving high-temperature reliability and reflow resistance of a semiconductor device obtained by using the resin composition for encapsulating, the content of the curing agent in the resin composition for encapsulating is preferably 25% by mass or less, more preferably 15% by mass or less, and still more preferably 10% by mass or less with respect to the entire resin composition for encapsulating.

(Inorganic filler)

The inorganic filler has a function of reducing increase in moisture absorption and decrease in strength associated with curing of the resin composition, and inorganic fillers commonly used in the field can be used.

Examples of the inorganic filler include fused silica, spherical silica, crystalline silica, alumina, silicon nitride, and aluminum nitride, and these inorganic fillers may be used alone or in combination.

An average particle diameter $D_{50}$ of the inorganic filler can be, for example, 0.01 $\mu$m or more and 150 $\mu$m or less.

A lower limit value of an amount of the inorganic filler in the resin composition is preferably 60% by mass or more, more preferably 70% by mass or more, and still more preferably 80% by mass or more with respect to the total mass of the resin composition. In a case where the lower limit value is within the above-described range, it is possible to more effectively reduce the increase in moisture absorption and decrease in strength associated with curing of the obtained resin composition, and as a result, solder crack resistance of the cured product can be further improved.

In addition, an upper limit value of the amount of the inorganic filler in the resin composition is preferably 93% by mass or less, more preferably 91% by mass or less, and still more preferably 90% by mass or less with respect to the total mass of the resin composition. In a case where the upper limit value is within the above-described range, the obtained resin composition has good fluidity and also has good moldability.

In a case of using an inorganic flame retardant including metal hydroxide such as aluminum hydroxide and magnesium hydroxide, zinc borate, zinc molybdate, and antimony trioxide, which will be described later, it is preferable that the total amount of these inorganic flame retardants and the above-described inorganic filler is within the above-described range.

(Other components)

The resin composition according to the embodiment of the present invention may contain a component shown below, in addition to the curing agent, the epoxy resin, and the inorganic filler.

(Curing accelerator)

A curing accelerator has a function of accelerating the reaction between the epoxy group of the epoxy resin and the reactive group of the curing agent, and curing accelerators commonly used in the field are used.

Specific examples of the curing accelerator include phosphorus atom-containing compounds such as organic phosphine, a tetra-substituted phosphonium compound, a phosphobetaine compound, an adduct of phosphine compound and quinone compound, and an adduct of phosphonium compound and silane compound; and nitrogen atom-containing compounds such as amidines exemplified by 1,8-diazabicyclo(5,4,0)undecene-7, benzyldimethylamine, and 2-methylimidazole, tertiary amines, and quaternary salts of the amidine and the amine, and one or two or more of these can be used in combination. Among these, from the viewpoint of curability, a phosphorus atom-containing compound is preferable, and from the viewpoint of solder resistance and fluidity, a phosphobetaine compound a phosphine compound, or an adduct of phosphine compound and quinone compound is particularly preferable. In addition, from the viewpoint of mild mold contamination during continuous molding, a phosphorus atom-containing compound such as a tetra-substituted phosphonium compound or an adduct of phosphonium compound and silane compound is particularly preferable.

Examples of the organic phosphine which can be used in the resin composition include primary phosphines such as ethylphosphine and phenylphosphine; secondary phosphines such as dimethylphosphine and diphenylphosphine; tertiary phosphines such as trimethylphosphine, triethylphosphine, tributylphosphine, and triphenylphosphine; and derivatives of these compounds.

(Coupling agent)

A coupling agent has a function of improving adhesiveness between the epoxy resin and the inorganic filler in a case where the resin composition contains the inorganic filler, and for example, a silane coupling agent or the like is used.

Various silane coupling agents can be used, but aminosilane is preferably used. As a result, the fluidity and solder resistance of the resin composition can be improved.

The aminosilane is not particularly limited, and examples thereof include γ-aminopropyltriethoxysilane, γ-aminopropyltrimethoxysilane, N-β-(aminoethyl)-γ-aminopropyltrimethoxysilane, N-β-(aminoethyl)-γ-aminopropylmethyldimethoxysilane, N-phenyl-γ-aminopropyltriethoxysilane, N-phenyl-γ-aminopropyltrimethoxysilane, N-β-(aminoethyl)-γ-aminopropyltriethoxysilane, N-6-(aminohexyl)-3-aminopropyltrimethoxysilane, and N-(3-(trimethoxysilylpropyl)-1,3-benzenedimethanamine.

A lower limit value of a blending proportion of the coupling agent such as the silane coupling agent in the entire resin composition is preferably 0.01% by mass or more, more preferably 0.05% by mass or more, and particularly preferably 0.1% by mass or more. In a case where the lower limit value of the blending proportion of the coupling agent such as the silane coupling agent is within the above-described range, good solder crack resistance in the electronic device can be obtained without decreasing interface strength between the epoxy resin and the inorganic filler. In addition, an upper limit value of the blending proportion of the coupling agent such as the silane coupling agent in the entire resin composition is preferably 1% by mass or less, more preferably 0.8% by mass or less, and particularly preferably 0.6% by mass or less. In a case where the upper limit value of the blending proportion of the coupling agent such as the silane coupling agent is within the above-described range, good solder crack resistance in the device can be obtained without decreasing interface strength between the epoxy resin and the inorganic filler. In addition, in a case where the blending proportion of the coupling agent such as the silane coupling agent is within the above-described range, good solder crack resistance in the electronic device can be obtained without increasing water absorption of the cured product of the resin composition.

(Inorganic flame retardant)

An inorganic flame retardant has a function of improving flame retardancy of the resin composition, and generally used inorganic flame retardants are used.

Specifically, metal hydroxides which inhibit a combustion reaction by dehydrating and absorbing heat during combustion, and composite metal hydroxides which can shorten the combustion time are preferably used.

Examples of the metal hydroxide include aluminum hydroxide, magnesium hydroxide, calcium hydroxide, barium hydroxide, and zirconia hydroxide.

The composite metal hydroxide is a hydrotalcite compound including two or more metal elements, in which at least one metal element is magnesium and other metal elements are metal elements selected from calcium, aluminum, tin, titanium, iron, cobalt, nickel, copper, or zinc, and as such a composite metal hydroxide, a magnesium hydroxide-zinc solid solution is commercially and readily available.

Among these, from the viewpoint of balance between the adhesiveness and the high-temperature reliability, aluminum hydroxide or a magnesium hydroxide-zinc solid solution is preferable.

The inorganic flame retardant may be used alone, or in combination of two or more thereof. In addition, for the purpose of reducing influence on the adhesiveness, the inorganic flame retardant may be surface-treated with a silicon compound such as a silane coupling agent or an aliphatic compound such as wax before use.

In the present invention, the inorganic flame retardant may be used, but it is preferable to not use a flame retardant in which, in a case where a weight of the inorganic flame retardant after being dried at 125°C for 20 hours and then cooled in a desiccator is defined as an initial weight, and a weight of the inorganic flame retardant after being put into a high-temperature bath at 200°C, heat-treated for 1000 hours, and then cooled in a desiccator is defined as a weight after treatment, a weight reduction rate after treatment is 0.1% by weight or more relative to the initial weight; and it is desirable that the resin composition is composed only of resins having flame retardancy, without further using the inorganic flame retardant.

That is, in the resin composition according to the embodiment of the present invention, since the epoxy resin includes the epoxy resin having 2 or more and 6 or less epoxy groups in the molecule, the curing agent includes the compound having 2 or more active hydrogens in the molecule, and the equivalent ratio which is a ratio of the epoxy equivalent of the epoxy resin to the active hydrogen equivalent of the curing agent is 1.4 or more and 2.0 or less, the resin composition has high flame retardancy and also functions as a flame retardant. Therefore, water is released at a high temperature of 200°C or higher, and as a result, even in a case where the blending of the metal hydroxide-based flame retardant, which may lead to an increase in weight reduction rate of the cured product, is omitted, the same properties as a case where the flame retardant is added are imparted to the resin composition.

In addition, in addition to the other components described above, coloring agents such as carbon black, red iron oxide, and titanium oxide; ion scavengers; mold release agents such as natural waxes including carnauba wax, synthetic

waxes including polyethylene wax, higher fatty acids including stearic acid and zinc stearate, metal salts thereof, and paraffin; and low-stress additives such as silicone oil and silicone rubber may be blended as appropriate.

The resin composition according to the embodiment of the present invention can be obtained by mixing the curing agent, the epoxy resin, and optionally the other components described above by a method commonly used in the field.

According to the present invention, a lower limit value of a glass transition temperature (Tg) of the above-described resin composition for encapsulating, which is measured by a thermomechanical analysis (TMA) under the conditions of a heating rate of 5 °C/min and a measurement mode of compression, is 210°C. In this case, a measurement start temperature is not particularly limited, but is, for example, 25°C.

By setting Tg to the above-described lower limit value or more, for example, in a case where an electronic component is encapsulated with the resin composition according to the present embodiment, it is possible to prevent a decrease in strength of the cured product of the resin composition and a decrease in adhesive strength between the resin composition and a lead frame or a substrate during a high-temperature treatment such as a reflow treatment, and to improve the high-temperature reliability.

In addition, an upper limit value of the glass transition temperature (Tg) of the above-described resin composition for encapsulating is 330°C, preferably 290°C, and more preferably 250°C. By setting Tg to the above-described upper limit value or less, for example, in a case where the resin composition according to the present embodiment is used for encapsulating an electronic component, elastic modulus of the cured product of the resin composition is not too high, which is advantageous for stress relaxation during encapsulating.

In one embodiment of the present invention, a lower limit value of a water absorption of the above-described resin composition, which is measured based on JIS K 7209, is preferably 0%, more preferably 0.1%, and still more preferably 0.28%.

By setting the water absorption to the above-described lower limit value or more, for example, in a case where the resin composition according to the present embodiment is used for encapsulating an electronic component, the adhesiveness between the resin composition and a lead frame or a substrate is excellent.

In addition, an upper limit value of the above-described water absorption is preferably 0.6%, more preferably 0.4%, and still more preferably 0.32%.

By setting the water absorption to the above-described upper limit value or less, for example, in a case where the resin composition according to the present embodiment is used for encapsulating an electronic component, the high-temperature reliability is excellent, and good solder crack resistance in the device can be obtained.

In one embodiment of the present invention, in a case where the above-described resin composition is heat-treated at 175°C for 120 seconds and then treated at 200°C for 4 hours to obtain a cured product, and the obtained cured product is measured using a dynamic viscoelasticity measuring apparatus, a lower limit value of a ratio $E'_{300}/E'_{350}$ of a storage modulus $E'_{300}$ at 300°C to a storage modulus $E'_{350}$ at 350°C is preferably 1.4, more preferably 1.45, and still more preferably 1.5. By setting the ratio $E'_{300}/E'_{350}$ to the above-described lower limit value or more, for example, in a case where the resin composition according to the present embodiment is used for encapsulating an electronic component, the adhesiveness between the resin composition and a lead frame or a substrate is excellent.

In addition, an upper limit value of the above-described $E'_{300}/E'_{350}$ is preferably 2.0, more preferably 1.95, and still more preferably 1.9. By setting the ratio $E'_{300}/E'_{350}$ to the above-described upper limit value or less, for example, in a case where the resin composition according to the present embodiment is used for encapsulating an electronic component, the high-temperature reliability is excellent, and good solder crack resistance in the device can be obtained.

In one embodiment of the present invention, in a case where the above-described resin composition is heat-treated at 175°C for 120 seconds and then treated at 200°C for 4 hours to obtain a cured product, and the obtained cured product is measured using a dynamic viscoelasticity measuring apparatus, a lower limit value of a ratio $E'_{350}/E'_{400}$ of a storage modulus $E'_{350}$ at 350°C to a storage modulus $E'_{400}$ at 400°C is preferably 1.4, more preferably 1.5, and still more preferably 1.6. By setting the ratio $E'_{350}/E'_{400}$ to the above-described lower limit value or more, for example, in a case where the resin composition according to the present embodiment is used for encapsulating an electronic component, the adhesiveness between the resin composition and a lead frame or a substrate is excellent.

In addition, an upper limit value of the above-described $E'_{350}/E'_{400}$ is preferably 2.0, more preferably 1.9, and still more preferably 1.8. By setting the ratio $E'_{350}/E'_{400}$ to the above-described upper limit value or less, for example, in a case where the resin composition according to the present embodiment is used for encapsulating an electronic component, the high-temperature reliability is excellent, and good solder crack resistance in the device can be obtained.

In one embodiment of the present invention, in a graph in which tan $\delta$ measured using a dynamic viscoelasticity measuring apparatus under conditions of a heating rate of 5 °C/min, a frequency of 10 Hz, and a measurement mode of compression is a vertical axis and a temperature (°C) is a horizontal axis, an inflection point at which a value of tan $\delta$ changes from decrease to increase is preferably the glass transition temperature or higher, more preferably 310°C or higher, and still more preferably 320°C or higher. With the above-described characteristic, for example, in a case where the resin composition according to the present embodiment is used for encapsulating an electronic component, the adhesiveness between the resin composition and a lead frame or a substrate is excellent.

In addition, the above-described inflection point is preferably 400°C or lower, more preferably 390°C or lower, and still more preferably 380°C or lower. With the above-described characteristic, for example, in a case where the resin composition according to the present embodiment is used for encapsulating an electronic component, the high-temperature reliability is excellent, and good solder crack resistance in the device can be obtained.
Although the reason for such an aspect is not clear, in the present embodiment, the equivalent ratio which is a ratio of the epoxy equivalent of the epoxy resin to the active hydrogen equivalent of the curing agent is higher than in the related art, and due to the epoxy-rich aspect, it is considered that the resin composition does not become a rubber-like elastic body even in a temperature range at which resin compositions in the related art may become the rubber-like elastic body, and the tan $\delta$ increases.
Next, a form of the resin composition for encapsulating will be described.
In the present embodiment, the form of the resin composition for encapsulating can be selected according to a molding method of the resin composition for encapsulating, and the like, and examples thereof include particles such as tablet, powder, and granule; and sheets.
In addition, with regard to a method for producing the resin composition for encapsulating, for example, the resin composition for encapsulating can be obtained by a method in which each of the above-described components is mixed by a known unit, further melt-kneaded by a kneader such as a roll, a kneader, and an extruder, cooled, and pulverized. In addition, after pulverization, the resin composition for encapsulating in a form of particles or sheets may be obtained by molding. For example, a particle-form resin composition for encapsulating may be obtained by tablet-molding into a tablet. In addition, for example, a sheet-form resin composition for encapsulating may be obtained by a vacuum extruder. In addition, dispersity, fluidity, and the like of the obtained resin composition for encapsulating may be adjusted as appropriate.
Since the resin composition for encapsulating obtained in the present embodiment has a high glass transition temperature, the resin composition for encapsulating has excellent adhesiveness with a metal member. More specifically, according to the present embodiment, it is also possible to improve adhesiveness between the encapsulating material and a member composed of Ag, Ni, Cu, or an alloy including one or more of these.
In addition, by using the resin composition for encapsulating obtained in the present embodiment, a semiconductor device having excellent high-temperature reliability can be obtained.
In one embodiment of the present invention, an electronic device can be obtained by encapsulating an electronic component with the above-described resin composition for encapsulating. As the electronic device, any known electronic devices can adopt the present embodiment, and for example, it is preferably used for a semiconductor package in which a semiconductor chip is encapsulated. In addition, a preferred aspect of the semiconductor chip is a semiconductor chip using silicon carbide (SiC) and gallium nitride (GaN).
In the present embodiment, the electronic device according to the present invention can be applied to various known forms of semiconductor packages, and it can be preferably applied to packages used in memory and logic devices, such as Dual Inline Package (DIP), Plastic Leaded Chip Carrier (PLCC), Quad Flat Package (QFP), Low Profile Quad Flat Package (LQFP), Small Outline Package (SOP), Small Outline J-Lead Package (SOJ), Thin Small Outline Package (TSOP), Thin Quad Flat Package (TQFP), Tape Carrier Package (TCP), Ball Grid Array (BGA), Chip Size Package (CSP), Matrix Array Package Ball Grid Array (MAPBGA), and Chip Stacked Chip Size Package. In addition, the electronic device according to the present invention can also be preferably applied to packages on which power devices such as a power transistor are mounted, such as TO-220.
The resin composition and the electronic device according to the embodiments of the present invention have been described above, but the present invention is not limited thereto.
For example, the resin composition according to the embodiment of the present invention may contain any component which can exhibit similar functions.
In addition, the configuration of each part of the electronic device according to the embodiment of the present invention can be replaced with any one of exhibiting similar functions, or any configuration can be added.

## EXAMPLES

### <Examples and Comparative Examples>

### (Preparation of resin composition for encapsulating)

With regard to each of Examples and Comparative Examples, a resin composition for encapsulating was prepared as follows.
First, each component shown in Table 1 was mixed with a mixer. Next, the obtained mixture was roll-kneaded, cooled, and pulverized to obtain a resin composition for encapsulating, which was a particulate object.
Details of each component in Table 1 are as follows. In addition, a blending proportion of each component shown

in Table 1 indicates a blending proportion (% by mass) with respect to the entire resin composition.

(Raw material)

(Inorganic filler)

Inorganic filler 1: fused silica (FB-560, manufactured by Denka Co., Ltd., average particle diameter: 30 μm)
Inorganic filler 2: fused silica (FB-105, manufactured by Denka Co., Ltd., average particle diameter: 10 μm)

(Coloring agent)

Coloring agent 1: carbon black (Carbon #5, manufactured by Mitsubishi Chemical Corporation)

(Silane coupling agent)

Silane coupling agent 1: phenylaminopropyltrimethoxysilane (CF4083, manufactured by Toray·Dow Corning)

(Epoxy resin)

Epoxy resin 1: polyfunctional epoxy resin (YL6677, manufactured by Mitsubishi Chemical Corporation, epoxy equivalent: 163 g/eq)
Epoxy resin 2: polyfunctional epoxy resin (HP-4700-RC, manufactured by DIC Corporation, epoxy equivalent: 156 g/eq; epoxy resin including the monomer represented by General Formula

(1) (m = n = 2))

(Curing agent)

Curing agent 1: triphenylmethane-type phenol resin (HE910-20, manufactured by AIR WATER INC., active hydrogen equivalent: 101)
Curing agent 2: biphenylene skeleton-containing polyfunctional phenol resin represented by Formula (2) (active hydrogen equivalent: 135)

[Chem. 3]

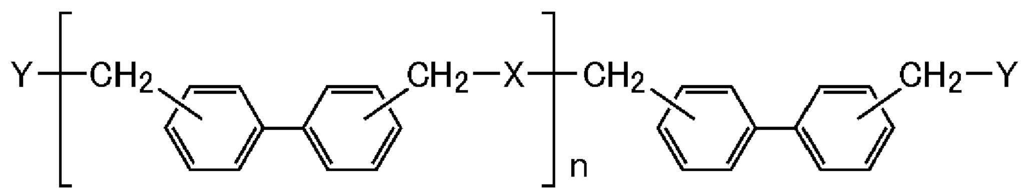

(2)

In Formula (2), two Y's each independently represent a hydroxyphenyl group represented by Formula (2-1) or Formula (2-2), and X represents a hydroxyphenylene group represented by Formula (2-3) or Formula (2-4). In addition, n represents an integer of 0 or more and 10 or less.

[Chem. 4]

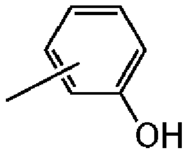

(2-1)

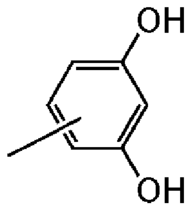

(2-2)

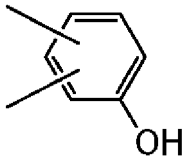

(2-3)

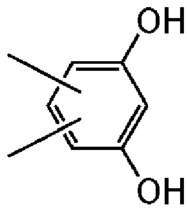

(2-4)

The above-described curing agent 2 was synthesized by the following method.

A separable flask was equipped with a stirrer, a thermometer, a reflux condenser, and a nitrogen inlet, 291 parts by mass of 1,3-dihydroxybenzene (manufactured by Tokyo Chemical Industry Co., Ltd., "Resorcinol", melting point: 111°C, molecular weight: 110, purity: 99.4%), 235 parts by mass of phenol (special grade reagent manufactured by KANTO CHEMICAL CO., INC., "Phenol", melting point: 41°C, molecular weight: 94, purity: 99.3%) and 125 parts by mass of pre-granulated 4,4'-bischloromethylbiphenyl (manufactured by Wako Pure Chemical Corporation, "4,4'-Bischloromethylbiphenyl", melting point: 126°C, purity: 95%, molecular weight: 251) were weighed in the separable flask, the mixture was heated while purging with nitrogen, and stirring was started at the time when the phenol started to melt.

Thereafter, the mixture was reacted for 3 hours while maintaining the temperature in the system within a range of 110°C to 130°C, and then heated and reacted for 3 hours while maintaining the temperature within a range of 140°C to 160°C.

Hydrochloric acid gas generated in the system by the above-described reaction was discharged out of the system by a nitrogen stream.

After the reaction was completed, unreacted components were distilled off under reduced pressure conditions of 150°C and 2 mmHg. Next, 400 parts by mass of toluene was added thereto and uniformly dissolved, the mixture was transferred to a separatory funnel, and after adding 150 parts by mass of distilled water and shaking, an operation of discarding the aqueous layer (water washing) was repeated until the washed water was neutral. Thereafter, the oil layer was treated under reduced pressure at 125°C to distill off volatile components such as toluene and residual unreacted components, thereby obtaining the curing agent 2 (polymer) represented by Formula (2) described above.

A hydroxyl group equivalent of the curing agent 2 was 135.

(Curing accelerator)

Curing accelerator 1: 4-hydroxy-2-(triphenylphosphonium) phenolate

(Mold release agent)

Mold release agent 1: carnauba wax (TOWAX-132, manufactured by TOAGOSEI CO., LTD.)

(Ion scavenger)

Ion scavenger 1: ion scavenger (DHT-4H, manufactured by Kyowa Chemical Industry Co., LTD.)

(Low-stress agent)

Low-stress agent 1: silicone oil (FZ-3730, manufactured by Toray·Dow Corning)

(Evaluation of physical properties)

Each physical property of the resin composition in each example was evaluated by the following methods.

(Spiral flow (SF) ·gel time)

The resin composition of each of Examples and Comparative Examples was injected into a mold for measuring spiral flow according to ANSI/ASTM D 3123-72 using a low-pressure transfer molding machine (KTS-15 manufactured by Kohtaki Corporation), under the conditions of 175°C, an injection pressure of 6.9 MPa, and a pressure holding time of 120 seconds, and a flow length was measured and defined as a spiral flow. In addition, a time from the start of injection until the resin composition cured and stopped flowing was measured and defined as a gel time.

The spiral flow is a parameter of fluidity, and as the value thereof is larger, the fluidity is better.

(Glass transition temperature (Tg) and TMA)

A glass transition temperature of the resin composition of each of Examples and Comparative Examples was measured according to JIS K 6911. That is, with the resin composition of each of Examples and Comparative Examples, using a transfer molding machine, a test piece of 80 mm × 10 mm × 4 mm was molded at a mold temperature of 175°C, an injection pressure of 6.9 MPa, and a curing time of 90 seconds, and then post-cured at 175°C for 2 hours. Thereafter, using a thermomechanical analysis device (manufactured by Seiko Instruments, Inc., TMA/SS6000), a coefficient of thermal expansion of the test piece was measured with a heating rate of 5 °C/min. Next, based on the obtained measurement results, the glass transition temperature (Tg) of the cured product was calculated from the inflection point of the coefficient of thermal expansion.

(Storage modulus, tan δ, and DMA)

A storage modulus E' of the resin composition of each of Examples and Comparative Examples was measured by the following method. That is, with the resin composition of each of Examples and Comparative Examples, using a transfer molding machine, a test piece of 80 mm × 10 mm × 4 mm was molded at a mold temperature of 175°C, an injection pressure of 6.9 MPa, and a curing time of 120 seconds, and then post-cured at 200°C for 4 hours. Thereafter, using a dynamic viscoelasticity measuring apparatus (manufactured by A&D Company, Limited, "DDV-25GP"), a storage modulus and tan δ were measured (heating rate: 5 °C/min, frequency: 10 Hz, load: 800 g).

With regard to each of Examples, in a graph in which the measured tan δ was a vertical axis and a temperature (°C) was a horizontal axis, an inflection point at which a value of tan δ changed from decrease to increase was present at a glass transition temperature or higher and 400°C or lower. On the other hand, with regard to each of Comparative Examples, the above-described inflection point was not present.

(Flexural modulus and bending strength)

The resin composition was injection-molded using a low-pressure transfer molding machine (manufactured by KOHTAKI Corporation, KTS-30) under the conditions of a mold temperature of 175°C, an injection pressure of 9.8 MPa, and a curing time of 120 seconds to obtain a molded product having a length of 80 mm, a width of 10 mm, and a thickness of 4 mm. As post-curing, the obtained molded product was heat-treated at 200°C for 4 hours to obtain a test piece, and a flexural modulus and bending strength were measured under ambient temperatures of 25°C and 260°C according to JIS K 6911.

(Water absorption)

The resin composition was injection-molded using a low-pressure transfer molding machine (manufactured by KOHTAKI Corporation, KTS-30) under the conditions of a mold temperature of 175°C, an injection pressure of 7.4 MP, and a curing time of 120 seconds to produce a test piece having a diameter of 50 mm and a thickness of 3 mm, and the test piece was cured at 200°C for 4 hours. Thereafter, the obtained test piece was subjected to a humidification treatment in a boiling environment for 24 hours, and a change in weight before and after the humidification treatment was measured to obtain a water absorption.

(Evaluation)

An evaluation sample was produced by the following method using the resin composition obtained in each of

Examples, and reliability of the obtained sample was evaluated by the following method.

(High-temperature reliability: HAST test)

With regard to the resin composition for encapsulating obtained in each of Examples, using a low-pressure transfer molding machine ("MSL-06M" manufactured by APIC YAMADA CORPORATION), 16 p SOP (Cu wire) was molded at a mold temperature of 175°C, an injection pressure of 10 MPa, and a curing time of 180 seconds, and cured at 200°C for 4 hours to produce a semiconductor device for testing. The encapsulated semiconductor device for testing was allowed to stand in an environment of a temperature of 130°C, a humidity of 85 %RH, and a voltage of 20 V, and a resistance value was measured every 40 hours up to 240 hours. A case where the resistance value was 1.2 times or more the initial value was evaluated as an unacceptable level, a case where the test was passed for 200 hours or more was evaluated as O, and a case where the test was failed before 200 hours was evaluated as X.

[Table 1]

| | | Example 1 | Example 2 | Example 3 | Example 4 | Example 5 | Comparative Example 1 | Comparative Example 2 | Comparative Example 3 |
|---|---|---|---|---|---|---|---|---|---|
| Component (% by mass) | Inorganic filler 1 | 69.00 | 69.00 | 69.00 | 69.00 | 69.00 | 69.00 | 69.00 | 69.00 |
| | Inorganic filler 2 | 15.00 | 15.00 | 15.00 | 15.00 | 15.00 | 15.00 | 15.00 | 15.00 |
| | Coloring agent 1 | 0.30 | 0.30 | 0.30 | 0.30 | 0.30 | 0.30 | 0.30 | 0.30 |
| | Silane coupling agent 1 | 0.20 | 0.20 | 0.20 | 0.20 | 0.20 | 0.20 | 0.20 | 0.20 |
| | Epoxy resin 1 | | | | | 2.41 | | | |
| | Epoxy resin 2 | 10.26 | 10.57 | 10.92 | 9.20 | 7.22 | 9.47 | 9.75 | 10.01 |
| | Curing agent 1 | 4.54 | 4.23 | 3.89 | | | 5.28 | 5.00 | 4.74 |
| | Curing agent 2 | | | | 5.60 | 5.17 | | | |
| | Curing accelerator 1 | 0.15 | 0.15 | 0.15 | 0.15 | 0.15 | 0.20 | 0.20 | 0.20 |
| | Mold release agent 1 | 0.20 | 0.20 | 0.20 | 0.20 | 0.20 | 0.20 | 0.20 | 0.20 |
| | Ion scavenger 1 | 0.15 | 0.15 | 0.15 | 0.15 | 0.15 | 0.15 | 0.15 | 0.15 |
| | Low-stress agent 1 | 0.20 | 0.20 | 0.20 | 0.20 | 0.20 | 0.20 | 0.20 | 0.20 |
| Total (% by mass) | | 100.00 | 100.00 | 100.00 | 100.00 | 100.00 | 100.00 | 100.00 | 100.00 |
| Equivalent ratio | | 1.45 | 1. 60 | 1.80 | 1.45 | 1.45 | 1.15 | 1.25 | 1.35 |

(continued)

| | | | Example 1 | Example 2 | Example 3 | Example 4 | Example 5 | Comparative Example 1 | Comparative Example 2 | Comparative Example 3 |
|---|---|---|---|---|---|---|---|---|---|---|
| Resin properties | Spiral flow (cm) | | 93 | 87 | 87 | 85 | 110 | 79 | 81 | 81 |
| | Gel time (sec) | | 20 | 19 | 20 | 18 | 19 | 22 | 19 | 19 |
| | Tg(°C) | | 226 | 222 | 218 | 225 | 215 | 199 | 200 | 199 |
| | $E'_{300}$(GPa) | | 5.8 | 5.8 | 6.4 | 7.7 | 6.0 | 7.9 | 7.6 | 6.1 |
| | $E'_{350}$(GPa) | | 3.7 | 3.6 | 3.8 | 4.2 | 3.9 | 4.2 | 4.3 | 4.0 |
| | $E'_{400}$(GPa) | | 2.2 | 2.1 | 2.3 | 2.4 | 2.1 | 2.8 | 2.8 | 2.6 |
| | $E'_{300}/E'_{350}$ | | 1.57 | 1.61 | 1.68 | 1.83 | 1.54 | 1.88 | 1.77 | 1.53 |
| | $E'_{350}/E'_{400}$ | | 1.68 | 1.71 | 1.65 | 1.75 | 1.86 | 1.50 | 1.53 | 1.54 |
| | Bending strength (MPa) | 25°C | 119 | 127 | 128 | 140 | 148 | 130 | 124 | 129 |
| | | 260°C | 31 | 35 | 35 | 41 | 36 | 33 | 32 | 31 |
| | Flexural modulus (GPa) | 25°C | 20 | 20 | 21 | 20 | 20 | 20 | 20 | 20 |
| | | 260°C | 4 | 5 | 5 | 6 | 6 | 5 | 5 | 4 |
| | Water absorption (%) | | 0.32 | 0.29 | 0.29 | 0.29 | 0.30 | 0.21 | 0.20 | 0.20 |
| Evaluation | HAST test | | 240h, ○ | 240h, ○ | 200h, ○ | 240h, ○ | 240h, ○ | 80h, X | 80h, X | 120h, X |

In Examples, since the glass transition temperature (Tg) was high and the result in the HAST test was good, it was possible to provide a resin composition for encapsulating, which had excellent adhesiveness and high-temperature reliability.

## Claims

1. A resin composition for encapsulating, comprising:

    an epoxy resin;
    a curing agent; and
    an inorganic filler,
    wherein the epoxy resin includes an epoxy resin having 2 or more and 6 or less epoxy groups in a molecule,
    the curing agent includes a compound having 2 or more active hydrogens in a molecule, and
    an equivalent ratio which is a ratio of an epoxy equivalent of the epoxy resin to an active hydrogen equivalent of the curing agent is 1.45 or more and 2.0 or less,
    wherein the epoxy resin includes a monomer represented by General Formula (1), and
    a glass transition temperature of the resin composition for encapsulating, which is measured by a thermomechanical analysis (TMA) under a condition of a heating rate of 5 °C/min, is 210°C or higher and 330°C or lower,

    [Chem. 1]

    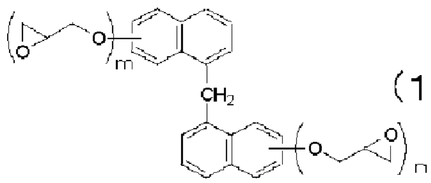

    (1)

    (in General Formula (1), m and n represent the number of epoxy groups in a naphthalene ring, and each independently represent an integer of 1 to 3).

2. The resin composition for encapsulating according to claim 1,
wherein the epoxy resin is a mixture of an epoxy resin including the monomer represented by General Formula (1) and one or two or more epoxy resins different from the monomer.

3. The resin composition for encapsulating according to claim 1 or 2,
wherein the curing agent includes one or two kinds of a polyfunctional phenol resin and a phenol aralkyl-type phenol resin.

4. The resin composition for encapsulating according to any one of claims 1 to 3,
wherein the curing agent includes a triphenylmethane-type phenol resin or a biphenylene skeleton-containing polyfunctional phenol resin.

5. The resin composition for encapsulating according to any one of claims 1 to 4,
wherein a water absorption measured based on JIS K 7209 is 0.6% or less.

6. The resin composition for encapsulating according to any one of claims 1 to 5,

    wherein, in a case where the resin composition for encapsulating is heat-treated at 175°C for 120 seconds and then treated at 200°C for 4 hours to obtain a cured product, and the obtained cured product is measured using a dynamic viscoelasticity measuring apparatus, a ratio $E'_{300}/E'_{350}$ of a storage modulus $E'_{300}$ at 300°C to a storage modulus $E'_{350}$ at 350°C is 1.4 or more and 2.0 or less,
    wherein the storage modulus E'300 at 300° C and the storage modulus E'350 at 350° C are determined in accordance with the method disclosed in the description.

7. The resin composition for encapsulating according to any one of claims 1 to 6,

wherein, in a case where the resin composition for encapsulating is heat-treated at 175°C for 120 seconds and then treated at 200°C for 4 hours to obtain a cured product, and the obtained cured product is measured using a dynamic viscoelasticity measuring apparatus, a ratio $E'_{350}/E'_{400}$ of a storage modulus $E'_{350}$ at 350°C to a storage modulus $E'_{400}$ at 400°C is 1.4 or more and 2.0 or less,
wherein the storage modulus E'350 at 350° C and the storage modulus E'40 at 400° C are determined in accordance with the method disclosed in the description.

8. The resin composition for encapsulating according to any one of claims 1 to 7,
wherein, in a graph in which tan $\delta$ measured using a dynamic viscoelasticity measuring apparatus under conditions of a heating rate of 5 °C/min, a frequency of 10 Hz, and a measurement mode of compression is a vertical axis and a temperature (°C) is a horizontal axis, an inflection point at which a value of tan $\delta$ changes from decrease to increase is present in a temperature range of a glass transition temperature or higher and 400°C or lower.

9. An electronic device comprising:
an electronic component encapsulated with the resin composition for encapsulating according to any one of claims 1 to 8.

**Patentansprüche**

1. Harzzusammensetzung zum Verkapseln, umfassend:

ein Epoxidharz;
ein Härtungsmittel; und
einen anorganischen Füllstoff,
wobei das Epoxidharz ein Epoxidharz mit 2 oder mehr und 6 oder weniger Epoxidgruppen in einem Molekül einschließt,
das Härtungsmittel eine Verbindung mit zwei oder mehr aktiven Wasserstoffatomen pro Molekül einschließt, und ein Äquivalenzverhältnis, welches ein Verhältnis eines Epoxidäquivalents des Epoxidharzes zu einem Äquivalent an aktivem Wasserstoff des Härtungsmittels ist, 1,45 oder mehr und 2,0 oder weniger beträgt,
wobei das Epoxidharz ein Monomer, dargestellt durch die allgemeine Formel (1), einschließt, und
eine Glasübergangstemperatur der Harzzusammensetzung zum Verkapseln, gemessen durch thermomechanische Analyse (TMA) unter einer Bedingung einer Aufheizrate von 5 °C /min, 210 °C oder höher und 330 °C oder niedriger beträgt,

[Chem. 1]

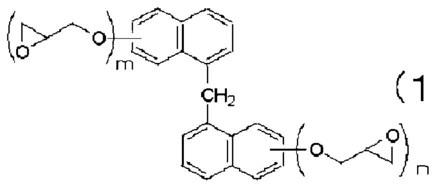

(1)

(in der allgemeinen Formel (1) bezeichnen m und n die Anzahl der Epoxidgruppen in einem Naphthalinring und stehen jeweils unabhängig voneinander für eine ganze Zahl von 1 bis 3).

2. Harzzusammensetzung zum Verkapseln nach Anspruch 1,
wobei das Epoxidharz ein Gemisch aus einem Epoxidharz, welches das in der allgemeinen Formel (1) dargestellte Monomer einschließt, und einem oder zwei oder mehreren Epoxidharzen, die sich von dem Monomer unterscheiden, ist.

3. Harzzusammensetzung zum Verkapseln nach Anspruch 1 oder 2,
wobei das Härtungsmittel ein oder zwei Arten eines polyfunktionellen Phenolharzes und eines Phenolharzes vom Phenol-Aralkyl-Typ einschließt.

4. Harzzusammensetzung zum Verkapseln nach einem der Ansprüche 1 bis 3,
wobei das Härtungsmittel ein Phenolharz vom Triphenylmethan-Typ oder ein Biphenylen-Gerüst enthaltendes

polyfunktionelles Phenolharz einschließt.

**5.** Harzzusammensetzung zum Verkapseln nach einem der Ansprüche 1 bis 4,
wobei die Wasseraufnahme gemäß JIS K 7209 0,6 % oder weniger beträgt.

**6.** Harzzusammensetzung zum Verkapseln nach einem der Ansprüche 1 bis 5,

wobei in einem Fall, in dem die Harzzusammensetzung zum Verkapseln 120 Sekunden lang bei 175 °C und anschließend 4 Stunden lang bei 200 °C wärmebehandelt wird, um ein ausgehärtetes Produkt zu erhalten, und das erhaltene ausgehärtete Produkt mit einem dynamischen Viskoelastizitätsmessgerät gemessen wird, das Verhältnis $E'_{300}$ /$E'_{350}$ des Speichermoduls $E'_{300}$ bei 300 °C zum Speichermodul $E'_{350}$ bei 350 °C 1,4 oder mehr und 2,0 oder weniger beträgt,
wobei der Speichermodul E'300 bei 300°C und der Speichermodul E'350 bei 350°C nach dem in der Beschreibung offenbarten Verfahren bestimmt werden.

**7.** Harzzusammensetzung zum Verkapseln nach einem der Ansprüche 1 bis 6,

wobei in einem Fall, in dem die Harzzusammensetzung zum Verkapseln 120 Sekunden lang bei 175 °C und anschließend 4 Stunden lang bei 200 °C wärmebehandelt wird , um ein ausgehärtetes Produkt zu erhalten, und das erhaltene ausgehärtete Produkt mit einem dynamischen Viskoelastizitätsmessgerät gemessen wird, das Verhältnis $E'_{350}$/$E'_{400}$ des Speichermoduls $E'_{350}$ bei 350 °C zum Speichermodul $E'_{400}$ bei 400 °C 1,4 oder mehr und 2,0 oder weniger beträgt,
wobei der Speichermodul E'350 bei 350°C und der Speichermodul E'400 bei 400°C gemäß dem in der Beschreibung offenbarten Verfahren bestimmt werden.

**8.** Harzzusammensetzung zum Verkapseln nach einem der Ansprüche 1 bis 7,
wobei in einem Diagramm, in dem tan $\delta$ mit einem dynamischen Viskoelastizitätsmessgerät unter den Bedingungen einer Heizrate von 5 °C /min, einer Frequenz von 10 Hz und einem Messmodus der Kompression auf der vertikalen Achse und die Temperatur (°C ) auf der horizontalen Achse gemessen wurde, ein Wendepunkt, an dem sich der Wert von tan $\delta$ von abnehmend zu zunehmend ändert, in einem Temperaturbereich von einer Glasübergangstemperatur oder höher und 400 °C oder niedriger vorhanden ist.

**9.** Elektronische Vorrichtung, umfassend:
ein elektronisches Bauteil, verkapselt mit der Harzzusammensetzung zum Verkapseln nach einem der Ansprüche 1 bis 8.

**Revendications**

**1.** Composition de résine pour encapsulation, comprenant :

une résine époxy ;
un agent durcissant ; et
une charge inorganique,
dans laquelle la résine époxy inclut une résine époxy ayant 2 ou plus et 6 ou moins groupes époxy dans une molécule,
l'agent durcissant inclut un composé ayant 2 hydrogènes actifs ou plus dans une molécule, et
un rapport équivalent qui est un rapport d'un équivalent d'époxy de la résine époxy sur un équivalent d'hydrogène actif de l'agent durcissant est de 1,45 ou plus et 2,0 ou moins,
dans laquelle la résine époxy inclut un monomère représenté par la Formule générale (1), et
une température de transition vitreuse de la composition de résine pour encapsulation, qui est mesurée par une analyse thermomécanique (TMA) à une condition d'un taux de chauffage de 5 °C/min est de 210 °C ou supérieure et 330 °C ou inférieure,

[Chim. 1]

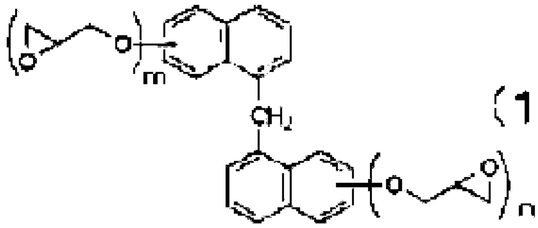

(1)

(dans la Formule générale (1), m et n représentent le nombre de groupes époxy dans un cycle de naphtalène, et représentent chacun indépendamment un entier de 1 à 3).

2. Composition de résine pour encapsulation selon la revendication 1, dans laquelle la résine époxy est un mélange d'une résine époxy incluant le monomère représenté par la Formule générale (1) et une ou deux résines époxy ou plus différentes du monomère.

3. Composition de résine pour encapsulation selon la revendication 1 ou 2, dans laquelle l'agent durcissant inclut un ou deux types d'une résine phénolique polyfonctionnelle et d'une résine phénolique de type aralkyle phénolique.

4. Composition de résine pour encapsulation selon l'une quelconque des revendications 1 à 3, dans laquelle l'agent durcissant inclut une résine phénolique de type triphénylméthane ou une résine phénolique polyfonctionnelle contenant un squelette de biphénylène.

5. Composition de résine pour encapsulation selon l'une quelconque des revendications 1 à 4, dans laquelle une absorption d'eau mesurée en fonction de JIS K 7209 est de 0,6 % ou moins.

6. Composition de résine pour encapsulation selon l'une quelconque des revendications 1 à 5,

dans laquelle, dans un cas où la composition de résine pour encapsulation est traitée thermiquement à 175 °C pendant 120 secondes, puis traitée à 200 °C pendant 4 heures pour obtenir un produit durci, et le produit durci obtenu est mesuré en utilisant un appareil de mesure de viscoélasticité dynamique, un rapport $E'_{300}/E'_{350}$ d'un module de stockage $E'_{300}$ à 300 °C sur un module de stockage $E'_{350}$ à 350 °C et de 1,4 ou plus et 2,0 ou moins, dans laquelle le module de stockage $E'_{300}$ à 300 °C et le module de stockage $E'_{350}$ à 350 °C sont déterminés conformément au procédé divulgué dans la description.

7. Composition de résine pour encapsulation selon l'une quelconque des revendications 1 à 6,

dans laquelle, dans un cas où la composition de résine pour encapsulation est traitée thermiquement à 175 °C pendant 120 secondes, puis traitée à 200 °C pendant 4 heures pour obtenir un produit durci, et le produit durci obtenu est mesuré en utilisant un appareil de mesure de viscoélasticité dynamique, un rapport $E'_{350}/E'_{400}$ d'un module de stockage $E'_{350}$ à 350 °C sur un module de stockage $E'_{400}$ à 400 °C et de 1,4 ou plus et 2,0 ou moins, dans laquelle le module de stockage $E'_{350}$ à 350 °C et le module de stockage $E'_{400}$ à 400 °C sont déterminés conformément au procédé divulgué dans la description.

8. Composition de résine pour encapsulation selon l'une quelconque des revendications 1 à 7, dans laquelle, dans un graphe dans lequel tan $\delta$ mesuré en utilisant un appareil de mesure de viscoélasticité dynamique à des conditions d'un taux de chauffage de 5 °C/min, d'une fréquence de 10 Hz, et un mode de mesure de compression est un axe vertical et une température (°C) est un axe horizontal, un point d'inflexion auquel une valeur de tan $\delta$ change de décroissance à croissance est présent dans une plage de température d'une température de transition vitreuse ou supérieure et 400 °C ou inférieure.

9. Dispositif électronique comprenant : un composant électronique encapsulé avec la composition de résine pour encapsulation selon l'une quelconque des revendications 1 à 8.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005167035 A
- US 2007207322 A1
- JP 2012241151 A